# EUROPEAN PATENT APPLICATION

(11) **EP 1 553 452 A2**
(43) Date of publication of application: **13.07.2005**
(21) Application number: 04257948.2
(22) Date of filing: 18.12.2004
(51) Int. Cl.: G03F 7/039

(54) **Photoresist compositions comprising polymers**

(30) Priority: 31.12.2003 US 534061 P
(71) Applicant: Rohm and Haas Electronic Materials, L.L.C., Marlborough, Massachusetts 01752 (US)
(72) Inventor: Chung, Dong Won, Worcester Massachusetts 01605 (US); Barclay, George G., Jefferson Massachusetts 01522 (US)
(74) Representative: Buckley, Guy Julian

(57) **Abstract**

The present invention relates to new polymers and use of such polymers as a resin binder component for photoresist compositions, particularly chemically-amplified positive-acting resists that can be effectively imaged at short wavelengths such as sub-200 nm, particularly 193 nm. Preferred polymers of the invention are terpolymers and tetrapolymers that can exhibit good adhesion to underlying inorganic surfaces such as SiON and Si₃N₄ surfaces and contain repeat units with pendant moieties having heteroatom substitution.

## Description

The present application claims the benefit of U.S. provisional application number 60/534,061, filed December 31, 2003, which is incorporated herein by reference in its entirety.

### BACKGROUND OF THE INVENTION

### 1. Field of the Invention

The present invention relates to new polymers and use of such polymers as a resin component for photoresist compositions, particularly chemically-amplified positive-acting resists that can be effectively imaged at short wavelengths such as sub-200 nm. Preferred polymers are terpolymers and tetrapolymers can exhibit good adhesion to underlying inorganic surfaces such as SiON and Si₃N₄ and contain repeat units with pendant moieties having hetero-atom substitution.

### 2. Background

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble.

While currently available photoresists are suitable for many applications, current resists also can exhibit significant shortcomings, particularly in high performance applications such as formation of highly resolved sub-quarter micron and even sub-tenth micron features.

Consequently, interest has increased in photoresists that can be photoimaged with short wavelength radiation, including exposure radiation of below 200 nm such as 193 nm.

Alicyclic polymers are of interest as resin components for photoresists imaged at sub-200 nm wavelengths due to the relatively low absorption of such resins to exposure radiation. Polymers of alicyclic monomers such as norbornene have been prepared by metal-mediated addition or ring-opening metathesis polymerization (ROMP), which suffers from the drawbacks of high cost and possible metal contamination. Alternatively, the electron-rich norbornene monomers can be radically copolymerized with electron-deficient maleic anhydride to produce alternating copolymers, which have been evaluated as 193 nm (ArF excimer laser) resist polymers. See U.S. Patent 6,509,134. See also T. Wallow et al., *Proc*. *SPIE* 2724 (1996) 334; S. J. Choi, et al., *J*. *Photopolymer Sci*. *Technology*, 10 (1997) 521; and S. J. Choi et al., *Proc. SPIE* 3999 (2000) 54; U.S. Patent 5,843,624; U.S. Patent 6,306,554; and U.S. Patent 6,517,990.

Silicon oxynitride (often depicted as SiON) layers and other inorganics such as silicon nitride (often depicted as Si₃N₄) coatings have been employed in semiconductor device manufacture, for example as an etch stop layer and an inorganic antireflective layer. See, for instance, U.S. Patents 6,124,217; 6,153,504; and 6,245,682.

### SUMMARY OF THE INVENTION

We have found that organic coating compositions such as photoresists and organic antireflective compositions can adhere relatively poorly to underlying inorganic surfaces such as a surface containing silicon oxynitride or silicon nitride. That poor adhesion will reduce resolution of a patterned photoresist relief image, which in turn can result in product defects, or render the resist unsuitable for the intended application.

We have now found photoresists of the invention can adhere will to such inorganic surface layers, including SiON layers and silicon nitride layers. See, for instance, the comparative data set forth in Examples 9 and 10, which follow. Photoresist compositions of the invention also can provide highly resolved relief images upon exposure to extremely short wavelengths, particularly sub-200 nm wavelengths such as 193 nm.

Polymers of the invention contain at least the following three distinct repeat units: 1) a repeat unit that comprises a polymerized carbon alicyclic group such as a polymerized norbornyl group; 2) a polymerized acrylate group (which includes substituted acrylates such methacrylates); and 3) a polymerized anhydride group such as a maleic anhydride. The polymer also will contain i) a photoacid-labile moiety (e.g. a photoacid-labile ester or acetal group), and ii) distinct from the photoacid-labile moiety, a pendant group that comprises one more hetero atoms (particularly N, O or S, preferably O or S) such as may be present as a component of an alcohol, alkylsulfide, lactone, ester, and the like.

Particularly preferred polymers of the invention are tetrapolymers and comprise the above units 1), 2) and 3), and a fourth (4)) distinct unit. Preferably, that fourth unit comprises the group ii) mentioned above that is distinct from the photoacid-labile groups and is a pendant group and contains one or more hetero atoms. A photoacid-labile moiety may be present on any of units 1), 2), 3) or 4), and preferably is a component of a carbon alicyclic unit or acrylate unit.

Without being bound by any theory, it believed that the hetero-containing polymer component (i.e. polymer moiety ii)) is responsible at least in part for enhancing adhesion of a coating layer of the polymer or a photoresist containing the polymer to an underlying inorganic substrate surface, such as a silicon oxynitride and/or silicon nitride (e.g. SiON or Si₃N₄) layer.

Preferably, the hetero-containing polymer component (i.e. polymer moiety ii) can provide a discemable increase in adhesion of the resist to a SiON surface layer. A discemable increase in adhesion is indicated by enhanced resolution relative to a control resist (same resist processed in same manner, with the sole difference being that the resist resin does not contain hetero-containing polymer component). Such enhanced resolution can be determined by visual inspection of scanning electron micrographs (SEMs) of the resist with hetero-containing polymer component ii) (test resist) and the control resist. Thus, preferred hetero-containing polymer components ii) (which impart a discernable increase in adhesion to an inorganic underlay) for any given resist system can be readily identified empirically. Preferred hetero-containing polymer components (i.e. component (ii)) and polymers are disclosed in detail herein.

Polymers of the invention also may contain units in addition to the above groups. For example, polymers of the invention contain an oxygen- and/or sulfur-containing heteroalicyclic ring that is fused to the polymer backbone (i.e. at least two heteroalicyclic ring atoms as part of the polymer backbone). The heteroalicyclic ring suitably has one or more oxygen and/or sulfur atoms as ring members. Polymers of the invention also may contain nitrile units such as provided by polymerization of methacrylonitrile and acrylonitrile. Additional contrast enhancing groups also may be present in polymers of the invention, such as groups provided by polymerization of methacrylic acid, acrylic acid, and such acids protected as photoacid labile esters, e.g. as provided by reaction of ethoxyethyl methacrylate, t-butoxy methacrylate, t-butylmethacrylate and the like.

Polymers of the invention are preferably employed in photoresists imaged at sub-200 nm such as 193 nm, and thus preferably will be substantially free of any phenyl or other aromatic groups. For example, preferred polymers contain less than about 5 mole percent aromatic groups, more preferably less than about 1 or 2 mole percent aromatic groups, more preferably less than about 0.1, 0.02, 0.04 and 0.08 mole percent aromatic groups and still more preferably less than about 0.01 mole percent aromatic groups. Particularly preferred polymers are completely free of aromatic groups. Aromatic groups can be highly absorbing of sub-200 nm radiation and thus are undesirable for polymers used in photoresists imaged with such short wavelength radiation.

The invention also provides methods for forming relief images, including methods for forming a highly resolved relief image such as a pattern of lines where each line has essentially vertical sidewalls and a line width of about 0.40 microns or less, and even a width of about 0.25, 0.20 or 0.16 microns or less. In such methods, preferably a coating layer of a resist of the invention is imaged with short-wavelength radiation, particularly sub-300 or sub-200 nm radiation, especially 248 nm, 193 nm, and 157 nm radiation, and higher energy radiation such as radiation having a wavelength of less than 100 nm, EUV, electron beam, ion beam or x-ray imaging.

The invention further provides articles of manufacture comprising substrates such as a microelectronic wafer substrate or liquid crystal display or other flat panel display substrate having coated thereon a polymer, photoresist or resist relief image of the invention.

The invention also includes substrates coated by a photoresist as disclosed herein, including substrates having an inorganic surface such as a coating of silicon oxynitride (e.g. SiON) and/or silicon nitride (e.g. Si₃N₄).

By stating herein that a cyclic group (e.g. a carbon alicyclic or heteralicyclic group) is fused to a polymer backbone, it is meant that two ring members of the cyclic group, typically two adjacent carbon atoms of the cyclic group, are also part of the polymer backbone. Such a fused ring can be provided by polymerizing a cyclic monomer that has an endocyclic double bond, e.g. by polymerizing an optionally substituted norbornene group.

As referred to herein, the term "carbon alicyclic group" means each ring member of the non-aromatic cyclic group is carbon. The carbon alicyclic group can have one or more endocyclic carbon-carbon double bonds, provided the ring is not aromatic.

In certain aspects of the invention, preferred polymers will be free of any heteroalicyclic groups (other than anhydride groups) that are fused to the polymer backbone, particularly fused cyclic ethers or cyclic thioethers.

Other aspects of the invention are disclosed infra.

### BRIEF DESCRIPTION OF THE DRAWINGS

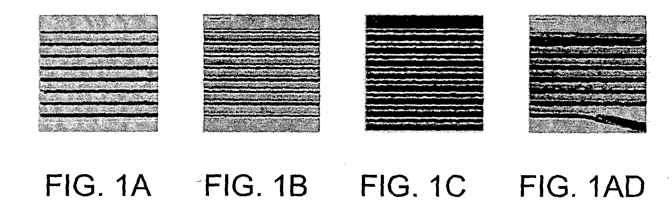

Figure 1 (which includes FIGS. 1A, 1B, 1C and comparative 1D) shows SEMs of the resist relief images produced in Example 9, which follows.

### DETAILED DESCRIPTION OF THE INVENTION

As discussed above, we now provide polymers that comprise at least the following three repeat units:
1) a repeat unit that comprises a polymerized carbon alicyclic group;
2) a repeat unit that comprises a polymerized acrylate group; and
3) a repeat unit that comprises a polymerized anhydride group.

Polymers of the invention also will contain the following two distinct groups, which may be present as component of any of the above repeat units 1), 2) and 3), or present as a component of further distinct repeat units:
i) a photoacid-labile moiety (e.g. a photoacid-labile ester or acetal group), and
ii) a pendant group that comprises one more hetero atoms.

Particularly preferred polymers of the invention are tetrapolymers and comprise the above units 1), 2) and 3), and a fourth (4)) distinct unit. Preferably, that fourth unit comprises the group ii) that is pendant to the polymer backbone and contains one or more hetero atoms.

By stating that units 1), 2) and 3) or units 1), 2), 3) and 4) are distinct, it is meant that no two of the units are structurally identical.

References herein to pendant group that comprises one more hetero atoms indicates a group where the one or more hetero atoms are not part of the linear polymer backbone, or are not part of a ring member of a cyclic group that is fused to the polymer backbone.

### Repeat units 1) of the polymer

Polymers of the invention will contain at least one repeat unit 1) that comprises a carbon alicyclic group (i.e. the group has all carbon ring members) that is fused to the polymer backbone, i.e. the carbon alicyclic ring has at least two carbon ring members that comprise the polymer backbone. Preferred fused carbon alicyclic groups are provided by polymerization of cyclic olefin (endocyclic double bond) compounds such as optionally substituted norbomene groups.

### Repeat units 2) of the polymer

Polymers of the invention also will contain at least one repeat unit 2) that comprises a polymerized acrylate group. Suitably, the polymerized acrylate group includes a photoacid-labile ester moiety.

More particularly, polymer repeat units 2) maybe provided by polymerization of an alkyl acrylate or alkylmethacrylate, particularly an acrylate having an alicyclic moiety such as methyladamantyl acrylate or methyladamantyl methacrylate. Preferred alicyclic photoacid-labile moieties are tertiary ester alicyclic hydrocarbon groups that have two or more fused or bridged rings. Preferred tertiary ester groups include optionally substituted adamantyl, particularly methyl adamantyl as mentioned above; optionally substituted fencyl groups, particularly ethyl fencyl; optionally substituted pinanyl; and optionally substituted tricyclo decanyl, particularly an alkyl-substituted tricyclo decanyl such as 8-ethyl-8-tricyclodecanyl e.g. as provided by polymerization of 8-ethyl-8-tricyclodecanyl acrylate and 8-ethyl-8-tricyclodecanyl methacrylate. Additional alicyclic ester groups also will be suitable, including additional bicyclic, tricyclic and other polycyclic moieties. The polymerized acrylate also may acyclic and preferably will undergo a cleavage reaction in the presence of photoacid, e.g. e.g. by polymerization of t-butylacrylate, t-butylmethacrylate and other acyclic acrylates such as disclosed in U.S. Patent 6,136,501 to Trefonas et al.

### Repeat units 3) of the polymer

Polymers of the invention also will contain at least one repeat unit 3) that comprises a polymerized anhydride group. A variety of anhydride groups will be suitable including e.g. maleic anhydride, itaconic anhydride, and the like. Polymerized maleic anhydride groups are generally preferred.

### Repeat units 4) of the polymer

Polymers may optionally comprise a fourth distinct repeat unit 4) that preferably includes a moiety that is pendant to the polymer backbone (i.e. covalently linked atoms that form the linear polymer chain) and comprise one or more hetero atoms.

A variety of moieties will be suitable pendant hetero-containing moieties including e.g. optionally substituted alcohols such as optionally substituted C₁₋₁₆alcohols more preferably optionally substituted-C₁₋₈alcohols with primary and secondary alcohols often being generally preferred while tertiary alcohols also can be suitable; lactones including bi-cyclic, tricyclic and other polycyclic lactones such as e.g. butyrolactones including alpha-butyrolactone.

Preferred pendant groups will contain hetero atoms (particularly oxygen or sulfur) that are spaced from the polymer backbone by at least 2, 3, 4 or 5 other atoms such as carbon atoms, typically saturated carbon atoms, such as may be present in a hydroxylalkyl (alcohol) group, a C₁₋₁₆alkylsulfide or the carbon ring members of a pendant lactone group.

The repeat units 4) will be distinct from acrylate groups 2) and anhydride groups 3) discussed above.

Preferred hetero-containing groups include groups that can promote solublization of a resin containing the groups in aqueous alkaline solution, e.g. tiols and alkylthiols such as C₁₋₈thiols, sulfonamide groups, including halogenated sulfonamide groups such as fluorinated sulfonamide groups, alcohols including halogenated especially fluorinated alcohols such as C₁₋₈alcohols that may be halogenated particularly fluorinated.

More particularly, preferred groups may include -CH₂C(OH)(CF₃)₂, --CH₂CH(OH)(CF₃), --CH(OH)(CF₃), -NHSO₂CF₃, -NHSO₂CH₃, -N(CH₃)SO₂CF₃, -N(CH₃)SO₂CHF₂ , and the like.

Such groups may be linked to a polymer backbone through a variety of groups include acyclic groups such as an optionally substituted C₁₋₈alkyl chain, or through an alicyclic group, i.e. where the hetero group is a substituent of an alicyclic group such as adamantly, norbomyl, cyclohexyl, cyopentyl, fenchyl, and the like. Specifically polymer groups of this type include the following:

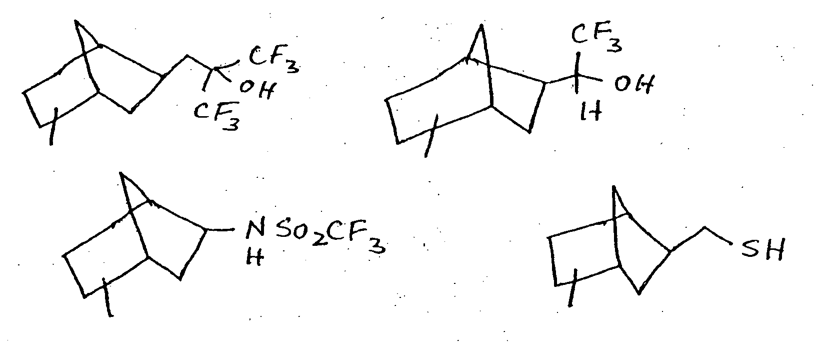

### Photoacid-labile groups and pendant hetero atom-containing groups

For use in photoresist compositions, polymers of the invention also will contain one or more units that comprise photoacid-labile moieties. The photoacid-labile group may be a substituent of one or more of the above-mentioned repeat units 1), 2), 3) or 4), such as a substituent of a polymerized carbon alicyclic group or a photoacid-labile ester component of a polymerized acrylate group. The photoacid labile moiety also may be present as an additional polymer unit, e.g. as a polymerized acrylate group that is distinct from unit 2), or as a substituent of a polymerized heteroalicyclic group that is preferably fused to the polymer backbone and preferably has one or more oxygen or sulfur atoms as ring members.

Preferred photoacid-labile groups include polymerized acrylate groups as discussed above, i.e. polymerized alkyl acrylate or alkylmethacrylate, particularly an acrylate having a tertiary alicyclic ester group, including polycyclic groups such adamantyl, ethylfencyl or a tricyclo decanyl moiety. References herein to a "tertiary alicyclic ester group" or other similar term indicate that a tertiary alicyclic ring carbon is covalently linked to the ester oxygen, i.e. -C(=O)O-TR' where T is a tertiary ring carbon of alicyclic group R'. In at least many cases, preferably a tertiary ring carbon of the alicyclic moiety will be covalently linked to the ester oxygen, such as exemplified by the below-depicted specifically preferred polymers. However, the tertiary carbon linked to the ester oxygen also can be exocyclic to the alicyclic ring, typically where the alicyclic ring is one of the substituents of the exocyclic tertiary carbon. Typically, the tertiary carbon linked to the ester oxygen will be substituted by the alicyclic ring itself, and/or one, two or three alkyl groups having 1 to about 12 carbons, more typically 1 to about 8 carbons, even more typically 1, 2, 3 or 4 carbons. The alicyclic group also preferably will not contain aromatic substitution. The alicyclic groups may be suitably monocyclic, or polycyclic, particularly bicyclic or tricyclic groups.

Preferred alicyclic moieties (e.g. group TR' of -C(=O)O-TR') of photoacid labile ester groups of polymers of the invention have rather large volume. It has been found that such bulky alicyclic groups can provide enhanced resolution when used in copolymers of the invention.

More particularly, preferred alicyclic groups of photoacid labile ester groups will have a molecular volume of at least about 125 or about 130 Å³, more preferably a molecular volume of at least about 135, 140, 150, 155, 160, 165, 170, 175, 180, 185, 190, 195, or 200 Å³. Alicyclic groups larger than about 220 or 250 Å³ may be less preferred, in at least some applications. References herein to molecular volumes designate volumetric size as determined by standard computer modeling, which provides optimized chemical bond lengths and angles. A preferred computer program for determining molecular volume as referred to herein is Alchemy 2000, available from Tripos. For a further discussion of computer-based determination of molecular size, see T Omote et al, *Polymers for Advanced Technologies,* volume 4, pp. 277-287.

Particularly preferred tertiary alicyclic groups of photoacid-labile units include the following, where the wavy line depicts a bond to the carboxyl oxygen of the ester group, and R is suitably optionally substituted alkyl, particularly C₁₋₈ alkyl such as methyl, ethyl, etc.

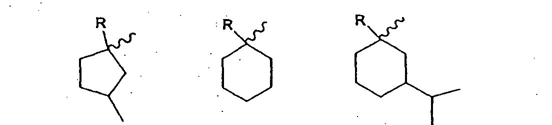

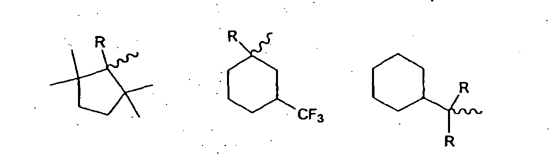

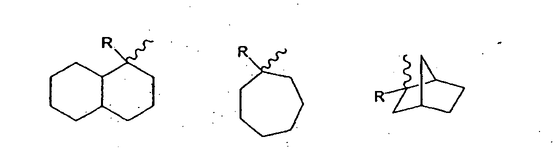

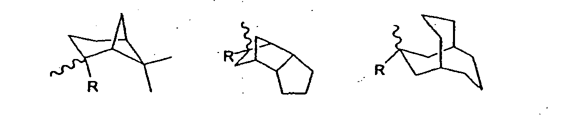

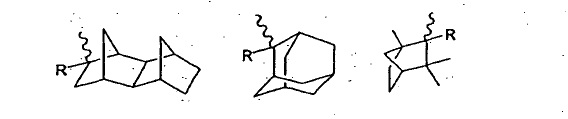

Polymers of the invention also may contain photoacid-labile groups that do not contain an alicyclic moiety. For example, polymers of the invention may contain photoacid-labile ester units, such as a photoacid-labile alkyl ester. Generally, the carboxyl oxygen (i.e. the carboxyl oxygen as underlined as follows: -C(=O)O) of the photoacid-labile ester will be covalently linked to the quaternary carbon. Branched photoacid-labile esters are generally preferred such as t-butyl and -C(CH₃)₂CH(CH₃)₂.

Suitable photoacid-labile groups also will include acetal groups such as may be provided by reaction of a vinyl ether such as ethyl vinyl ether with a hydroxy group.

Preferred polymers of the invention will contain at least about 2 to 5 mole percent of fused carbon alicyclic units (i.e. units 1)) based on total units of the polymer; more preferably from about 5 to 50 mole percent of fused carbon alicyclic units based on total units of the polymer, still more preferably from about 5 or 10 to about 40 or 50 percent of fused carbon alicyclic units based on total units of the polymer.

Preferred polymers of the invention will contain at least about 2 to 5 mole percent of polymerized acrylate units (i.e. units 2)) based on total units of the polymer; more preferably from about 5 to 50 mole percent of polymerized acrylate units based on total units of the polymer; still more preferably from about 5 or 10 to about 40 or 50 percent of polymerized acrylate units based on total units of the polymer.

Preferred polymers of the invention will contain at least about 2 to 5 mole percent of repeat units that comprise a polymerized anhydride group such as maleic anhydride group (i.e. units 3)) based on total units of the polymer; more preferably from about 5 to 50 mole percent of repeat units that comprise a polymerized anhydride group such as maleic anhydride group based on total units of the polymer.

Preferred polymers of the invention will contain at least about 2 to 5 mole percent of additional repeat units distinct from units 1), 2) and 3) (i.e. units 4)) that comprise a pendant hetero-atom containing moiety such as a lactone or alcohol; more preferably from about 5 to 30 or 40 mole percent of such distinct repeat units that comprise a pendant hetero-atom containing moiety such as a lactone or alcohol.

Preferred photoacid-labile groups are ester groups, particularly esters that contain a tertiary alicyclic hydrocarbon ester moiety

Polymers of the invention also may contain additional units such as cyano units, lactone units or anhydride units. For example, acrylonitrile or methacrylonitrile may be polymerized to provide pendant cyano groups, or maleic anhydride may be polymerized to provide a fused anhydride unit.

As discussed, various polymer moieties may be optionally substituted. A "substituted" polymer moiety or substituent may be substituted at one or more available positions, typically 1, 2, or 3 positions by one or more suitable groups such as e.g. halogen (particularly F, Cl or Br); cyano; C₁₋₈ alkyl; C₁₋₈ alkoxy; C₁₋₈ alkylthio; C₁₋₈ alkylsulfonyl; C₂₋₈ alkenyl; C₂₋₈ alkynyl; hydroxyl; nitro; alkanoyl such as a C₁₋₆ alkanoyl e.g. acyl and the like; etc.

Polymers of the invention can be prepared by a variety of methods. One suitable method is an addition reaction which may include free radical polymerization, e.g., by reaction of selected monomers to provide the various units as discussed above in the presence of a radical initiator under an inert atmosphere (e.g., N₂ or argon) and at elevated temperatures such as about 70°C or greater, although reaction temperatures may vary depending on the reactivity of the particular reagents employed and the boiling point of the reaction solvent (if a solvent is employed). Suitable reaction solvents include e.g. tetrahydrofuran, ethyl lactate and the like. Suitable reaction temperatures for any particular system can be readily determined empirically by those skilled in the art based on the present disclosure. A variety of free radical initiators may be employed. For example, azo compounds may be employed such as azo-bis-2,4-dimethylpentanenitrile. Peroxides, peresters, peracids and persulfates also could be employed.

Other monomers that can be reacted to provide a polymer of the invention can be identified by those skilled in the art: For example, to provide photoacid-labile units, suitable monomers include e.g. methacrylate or acrylate that contains the appropriate group substitution (e.g. tertiary alicyclic, t-butyl, etc.) on the carboxy oxygen of the ester group. Maleic anhydride is a preferred reagent to provide fused anhydride polymer units. Itaconic anhydride also is a preferred reagent to provide anhydride polymer units, preferably where the itaconic anhydride has purified such as by extraction with chloroform prior to polymerization. Vinyl lactones may be polymerized, such as alpha-butyrolactone. Some suitable vinyl (endocyclic double bond) heterocyclic monomers that can be polymerized include those disclosed in U.S. Patent 6306554 to Barclay et al.

Particularly preferred reagents, reaction conditions and polymers of the invention are described in Examples 1 through 4, which follow.

Preferably a polymer of the invention will have a weight average molecular weight (Mw) of about 800 or 1,000 to about 100,000, more preferably about 2,000 to about 30,000, still more preferably from about 2,000 to 15,000 or 20,000, with a molecular weight distribution (Mw/Mn) of about 3 or less, more preferably a molecular weight distribution of about 2 or less. Molecular weights (either Mw or Mn) of the polymers of the invention are suitably determined by gel permeation chromatography.

Polymers of the invention used in photoresist formulations should contain a sufficient amount of photoacid labile groups to enable formation of resist relief images as desired. For instance, suitable amount of such acid labile ester groups will be at least 1 mole percent of total units of the polymer, more preferably about 2 to 50 mole percent, still more typically about 3 to 30 or 40 mole percent of total polymer units. See the examples which follow for exemplary preferred polymers.

As discussed above, the polymers of the invention are highly useful as a resin component in photoresist compositions, particularly chemically-amplified positive resists. Photoresists of the invention in general comprise a photoactive component and a resin component that comprises a polymer as described above.

The resin component should be used in an amount sufficient to render a coating layer of the resist developable with an aqueous alkaline developer.

The photoactive component of a resist composition of the invention suitably comprises one or more photoacid generator compounds (i.e. "PAG") that are suitably employed in an amount sufficient to generate a latent image in a coating layer of the resist upon exposure to activating radiation. Preferred PAGs for imaging at 193 nm and 248 nm imaging include imidosulfonates such as compounds of the following formula: 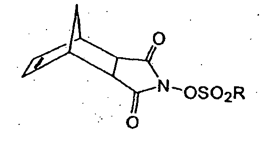 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs, particularly sulfonate salts. Two suitable agents for 193 nm and 248 nm imaging are the following PAGS 1 and 2:

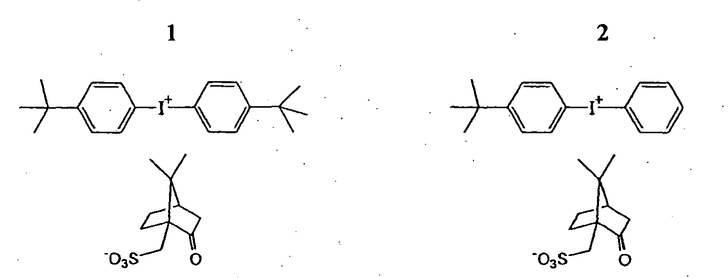

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Other known PAGS also may be employed in the resists of the invention. Particularly for 193 nm imaging, generally preferred are PAGS that do not contain aromatic groups, such as the above-mentioned imidosulfonates, in order to provide enhanced transparency.

A preferred optional additive of resists of the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Photoresists of the invention also may contain other optional materials. For example, other optional additives include anti-striation agents, plasticizers, speed enhancers, etc. Such optional additives typically will be present in minor concentrations in a photoresist composition except for fillers and dyes which may be present in relatively large concentrations, e.g., in amounts of from about 5 to 30 percent by weight of the total weight of a resist's dry components.

The resists of the invention can be readily prepared by those skilled in the art. For example, a photoresist composition of the invention can be prepared by dissolving the components of the photoresist in a suitable solvent such as, for example, ethyl lactate, ethylene glycol monomethyl ether, ethylene glycol monomethyl ether acetate, propylene glycol monomethyl ether; propylene glycol monomethyl ether acetate and 3-ethoxyethyl propionate. Typically, the solids content of the composition varies between about 5 and 35 percent by weight of the total weight of the photoresist composition. The resin binder and photoactive components should be present in amounts sufficient to provide a film coating layer and formation of good quality latent and relief images. See the examples which follow for exemplary preferred amounts of resist components.

The compositions of the invention are used in accordance with generally known procedures. The liquid coating compositions of the invention are applied to a substrate such as by spinning, dipping, roller coating or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon wafers or silicon wafers coated with silicon dioxide for the production of microprocessors and other integrated circuit components. Aluminum-aluminum oxide, gallium arsenide, ceramic, quartz, copper, glass substrates and the like are also suitably employed.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, the exposure energy typically ranges from about 1 to 100 mJ/cm², dependent upon the exposure tool and the components of the photoresist composition.

As discussed above, coating layers of the resist compositions of the invention are preferably photoactivated by a short exposure wavelength, particularly a sub-300 and sub-200 nm exposure wavelength. As discussed above, 193 nm is a particularly preferred exposure wavelength. However, the resist compositions of the invention also may be suitably imaged at higher wavelengths. For example, a resin of the invention can be formulated with an appropriate PAG and sensitizer if needed and imaged at higher wavelengths e.g. 248 nm or 365 nm.

Following exposure, the film layer of the composition is preferably baked at temperatures ranging from about 70°C to about 160°C. Thereafter, the film is developed. The exposed resist film is rendered positive working by employing a polar developer, preferably an aqueous based developer such as quaternary ammonium hydroxide solutions such as a tetra-alkyl ammonium hydroxide solution; various amine solutions preferably a 0.26 N tetramethylammonium hydroxide, such as ethyl amine, n-propyl amine, diethyl amine, di-n-propyl amine, triethyl amine, or methyldiethyl amine; alcohol amines such as diethanol amine or triethanol amine; cyclic amines such as pyrrole, pyridine, etc. In general, development is in accordance with procedures recognized in the art.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a halogen plasma etchant such as a chlorine or fluorine-based etchant such a Cl₂ or CF₄/CHF₃ etchant applied as a plasma stream. After such processing, resist may be removed from the processed substrate using known stripping procedures.

All documents mentioned herein are incorporated herein by reference. The following non-limiting examples are illustrative of the invention. In Examples 1 through 4, the structure of the polymer produced in the disclosed procedure is shown immediately below the Example title.

### Example 1. Synthesis of MAMA/BLA/MA/Nor tetrapolymer

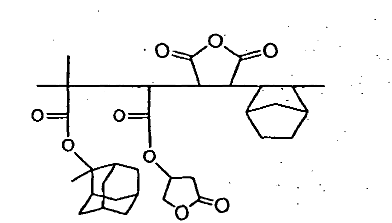

Mixture(1): A mixture of methyladamantanemethacrylate (14.06g; 0.06mol), β-butylolactoneacrylate (8.51g; 0.04mol) and maleic anhydride(3.92g;0.05mol) in 26.49g of inhibitor free tetrahydrofuran was placed in a round-bottom flask. After stirring for 1hr in a nitrogen bubbling atmosphere, the mixture was transferred to a 100ml syringe.

Mixture(2); The same procedure was used for mixture 2. A mixture of norbornene(4.71g;0.05mol) and V601(0.92g;0.004mol)in 50g of anhydride inhibitor free tetrahydrofuran(5.63g) was placed in a round -bottomed flask.
Polymerization and Precipitation; After stirring of mixture(2) for 1hr in a nitrogen bubbling atmosphere, the flask was put into a pre-heated 75°C oil bath. The stirring was continued at that temperature. At the same time, the mixture(1) was continuously fed into the reaction flask by syringe pump for 3.5 hours. When the feeding was finished, the total reaction mixture was stirred at same temperature(75°C) for 30minutes. After cooling, 100g of tetrahydrofuran was added to the reaction mixture. The polymer was isolated by precipitation into 2L of isopropyl alcohol. The suspension was stirred for 30minutes. Then, the polymer was filtered off, and the filtered polymer was washed with an additional 300ml isopropyl alcohol. The polymer was dried overnight in a vacuum oven at 45 °C (about 20hours). The polymer yield was 65%

### Example 2. Synthesis of MAMA/NLA/MA/Nor tetrapolymer

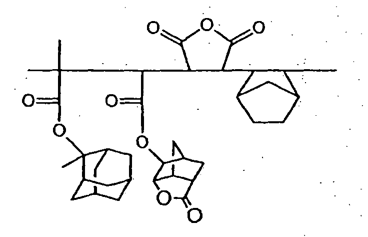

The title polymer was prepared by the same procedures as described above in Example 1, except that 8.23g (0.04mol) ofnorbomenelactoneacrylate was used in the place of β-butylolactoneacrylate. The polymer yield was 63%.

### Example 3. Synthesis of MAMA/HAdA/MA/Nor tetrapolymer

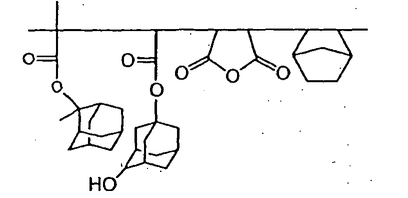

The title polymer was prepared by the same procedures as described above in Example 1, except that 8.89g (0.04mol)g of hydroxyadamantane-1-acrylate was used in the place of β-butylolactoneacrylate, the polymer was isolated by precipitation into 2L of isopropyl alcohol/hexane 1:1 mixture, and the filtered polymer was washed with an additional 300ml of isopropyl alcohol/hexane 1:1 mixture. The polymer yield was 60%.

### Example 4. Synthesis of MAMA/BLA/MA/NIPOH tetrapolymer

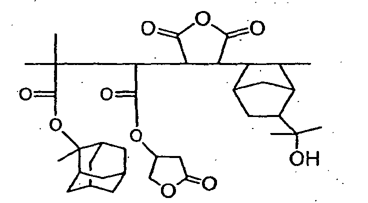

The title polymer was prepared by the same procedures as described above in Example 3, except that 7.61 g (0.05mol) of 5-norbomene-2-isoporpyl alcohol was used in the place of norbornene. The polymer yield was 63%.

### Example 5. Photoresist containing MAMA/BLA/MA/Nor tetrapolymer

MAMA/BLA/MA/Nor resist material were prepared with cyclohexanone. The resulting solution was about 10 weight percent polymer. A photoacid generator, triphenylsulfonium trifluoromethanesulfonate and triphenylsulfonium nonafluorobutanesulfonate was added to the solution in an amount that was about 1.5 weight percent by weight percent relative to the amount of polymer in the solution. The solution was filtered using PTFE membranes with average pore size that was less than 0.2 microns.

### Example 6. Photoresist containing MAMA/NLA/MA/Nor tetrapolymer

The formulation of MAMA/NLA/MA/Nor tetrapolymer was prepared by the same procedures as described above in Example 5, except that MAMA/NLA/MA/Nor tetrapolymer was used in the place of MAMA/BLA/MA/Nor tetrapolymer.

### Example 7. Photoresist containing MAMA/HAdA/MA/Nor tetrapolymer

The formulation of MAMA/HAdA/MA/Nor tetrapolymer was prepared by the same procedures as described above in Example 5, except that MAMA/NLA/MA/Nor tetrapolymer was used in the place of MAMA/BLA/MA/Nor tetrapolymer.

### Example 8. Photoresist containing MAMA/BLA/MA/NIPOH tetrapolymer

The formulation of MAMA/BLA/MA/NIPOH tetrapolymer was prepared by the same procedures as described above in Example 5, except that MAMA/NLA/MA/Nor tetrapolymer was used in the place of MAMA/BLA/MA/Nor tetrapolymer.

### Example 9. Patterning test of photoresists of Examples 5 through 8

Each of the photoresist compositions prepared in Examples 5 through 8 above were spun at 2500rpm onto HMDS-primed silicon wafer on which SiON(thickness=300Å) was deposited. The coated wafers were baked 120°C for 90 seconds on hot plate the resist films had a thickness of about 300Å. The wafers were then pattemwise exposed to radiation at a wavelength 193nm using a ISI 193 stepper.

The exposed wafers were than baked at 120°C for 60 seconds. The wafers were developed in an aqueous base solution(0.262N solution of tetramethyammonium hydroxide) for about 60 seconds. These developed wafers were checked by In-line SEM or X-SEM.

The patterning results are shown as Scanning Electron Micrographs (SEMs) in Figure 1. Specifically, FIG. 1A shows the relief image produced by the photoresist of Example 5 which contained the tetrapolymer of MAMA/BLA/MA/Nor; FIG. 1B shows the relief image produced by the photoresist of Example 6 which contained the tetrapolymer of MAMA/NLA/MA/Nor; FIG. 1C shows the relief image produced by the photoresist of Example 7 which contained the tetrapolymer of MAMA/HAdA/MA/Nor, FIG. 1D shows the relief image produced by the photoresist of Example 5 which contained the tetrapolymer of MAMA/BLA/MA/NIPOH.

### Example 10: Comparative results

A photoresist was prepared as described in Example 5, except the resin component had the following repeat units: 1) norbornene isopropyl alcohol, 2) maleic anhydride; 3) dihydropyran; and 4) methyladamantylmethacrylate, i.e. the polymer did not have a pendant moiety with heterocyclic substitution and in place thereof had a fused heteroalicyclic moiety (i.e. the polymerized dihydropyran).

That photoresist was processed over a SiON layer as described in Example 9. The Scanning Electron Micrograph of the developed image showed that all relief images patterned had lifted from the SiON substrate surface, i.e. adhesion failure had occurred.

The foregoing description of the invention is merely illustrative thereof, and it is understood that variations and modification can be made without departing from the spirit or scope of the invention as set forth in the following claims.

## Claims

1. A photoresist composition comprising a photoactive component and a polymer that comprises:
1) a repeat unit that comprises a polymerized carbon alicyclic group;
2) a repeat unit that comprises a polymerized acrylate group; and
3) a repeat unit that comprises a polymerized anhydride group;
i) a photoacid-labile moiety; and ii) a pendant group that comprises one more hetero atoms,
wherein each of repeat units 1), 2) and 3) are distinct polymer units.

2. The photoresist of claim 1 wherein the polymer further comprises:
4) a repeat unit that comprises the group ii) that is pendant to the polymer backbone and contains one or more hetero atoms, and
each of repeat units 1), 2), 3) and 4) are distinct polymer units.

3. The photoresist of claim 1 wherein the polymerized carbon alicyclic group is an optionally substituted norbornyl group.

4. The photoresist of claim 1 wherein the polymerized acrylate group contains a photoacid-labile ester.

5. The photoresist of claim 1 wherein the anhydride is maleic anhydride.

6. The photoresist of claim 1 wherein the pendant group is a lactone or alcohol.

7. The photoresist of claim 1 wherein the polymer does not contain a fused heteroalicyclic group.

8. The photoresist of claim 1 wherein the polymer is at least substantially free of aromatic groups.

9. A photoresist of claim 1 wherein the polymer is a tetrapolymer and comprises:
1) a repeat unit that comprises a polymerized optionally substituted norbornene alicyclic group;
2) a repeat unit that comprises a polymerized acrylate group that contains a photoacid-labile ester moiety; and
3) a repeat unit that comprises a polymerized maleic anhydride group;
4) a repeat unit that comprises a pendant lactone or alcohol group.
wherein each of repeat units 1), 2), 3) and 4) are distinct polymer units.

10. A substrate having thereon a coating layer of a photoresist of claim 1.

11. A substrate having an inorganic surface, a photoresist of claim 1 on the inorganic surface.

12. The substrate of claim 11 wherein the surface is silicon oxynitride and/or silicon nitride.

13. A method for forming a photoresist relief image comprising:
applying a photoresist of claim 1 on a substrate surface;
exposing the photoresist to patterned radiation; and
developing the exposed photoresist to provide a relief image.

14. The method of claim 13 the substrate surface comprises silicon oxynitride and/or silicon nitride.

15. The method of claim 13 wherein the radiation has a wavelength of less than 200 nm.

16. The method of claim 13 wherein the radiation has a wavelength of 193 nm.
